# EUROPÄISCHE PATENTSCHRIFT

(11) **EP 1 031 842 B1**
(45) Veröffentlichungstag und Bekanntmachung des Hinweises auf die Patenterteilung: **18.05.2005**
(21) Anmeldenummer: 00102675.6
(22) Anmeldetag: 09.02.2000
(51) Int. Cl.: G01R 31/30

(54) **Einrichtung zum Testen der Funktionstüchtigkeit einer kontaktbehafteten Chipkarte**
Device for testing the performance of a chip card with contacts
Appareil d'essai des performances d'une carte à puce avec des contacts

(30) Priorität: 26.02.1999 DE 19908379
(43) Veröffentlichungstag der Anmeldung: 30.08.2000
(73) Patentinhaber: BÖWE Cardtec GmbH, 33106 Paderborn (DE)
(72) Erfinder: Konze, Bernhard, 33100 Paderborn (DE); Velsen, J-rgen, 33165 Lichtenau (DE); Gross, Hans-Gerd, 33098 Paderborn (DE)

(56) Entgegenhaltungen:
- EP-A- 0 528 598
- EP-A- 0 856 794
- GB-A- 2 310 290
- US-A- 5 025 344
- 1990, HEWLETT-PACKARD TEST UND MESSTECHNIK HAUPTKATALOG, REUTLINGEN * Seite 524 - Seite 528 *

## Beschreibung

Die Erfindung bezieht sich auf eine Einrichtung zum Testen der Funktionstüchtigkeit einer kontaktbehafteten Chipkarte. Solche Chipkarten sind Form von Telefonkarten, Krankenversichertenkarten o.dgl. weit verbreitet. Dabei weisen die kontaktbehafteten Chipkarten elektrische Kontaktflächen auf, die mit entsprechenden Anschlußstellen des in der Chipkarte enthaltenen Halbleiterbausteins verbunden sind. Der Betrieb und die Kommunikation des Halbleiterbausteins mit externen Geräten (Chipkarten-Terminals) erfolgt dann über dieser Kontaktflächen im Berührungskontakt.

Derartige Chipkarten enthalten in einer sacklochartigen Aussparung des Kartenkörpers ein Chipmodul als Trägerelement für den Halbleiterbaustein, auf dem die Kontaktflächen angeordnet sind. Dabei wird die elektrische Verbindung zwischen den Anschlußstellen des Halbleiterbausteins und den Kontaktflächen über dünne Aluminium- oder Golddrähte hergestellt, die in der sogennanten Bondtechnik befestigt werden. Zum Schutz vor mechanischen Belastungen sind der Halbleiterbaustein und die Verbindungsdrähtchen mit einer schützenden UV- oder thermisch aushärtenden Vergußmasse umgeben.

Alternativ hierzu gibt es Chipmodule, bei denen die Anbindung des Halbleiterbausteins an die Kontaktflächen mit Hilfe der sogenannten Flip-Chip-Technik durchgeführt wird, wobei der Halbleiterbaustein mit seinen Anschlußstellen ohne Verbindungsdrähtchen direkt, z.B. mittels eines leitfähigen Klebers, auf den Rückseiten der Kontaktflächen elektrisch leitend fixiert wird.

Darüber hinaus sind kontaktbehaftete Chipkarten bekannt, bei denen kein Chipmodul als Zwischenerzeugnis in den Kartenkörper eingesetzt wird, sondern zur Ausbildung von Kontaktflächen direkt auf die Kartenoberfläche eine leitfähige Druckfarbe aufgebracht wird, die mit den Anschlußstellen des Halbleiterbaustein verbunden ist.

Die Halbleiterbausteine werden in Form eines Wafers, auf dem sich eine Vielzahl von Halbleiterbausteinen befinden, vom Halbleiterhersteller an den Kartenhersteller geliefert. Dabei wurden die Halbleiterbausteine an sich zuvor beim Halbleiterhersteller auf ihre Funktionstüchtigkeit überprüft. Beim Kartenhersteller werden mit den Halbleitern Chipmodule hergestellt, die dann zur Ausbildung einer fertigen Chipkarte in Kartenkörper eingesetzt werden. Dabei sind Verarbeitungsfehler, die zu defekten Chipkarten oder Chipmodulen führen, allerdings niemals vollständig auszuschließen. Ein Defekt ist beispielsweise eine fehler- oder mangelhafte Verbindung zwischen den Kontaktflächen und den Anschlußstellen am Halbleiterbaustein aufgrund eines gebrochenen Verbindungsdrähtchens oder aufgrund einer nur unzureichenden Fixierung der Enden der Verbindungsdrähtchen auf den Kontaktflächen und/oder auf den Anschlußstellen des Halbleiterbausteins - die Verbindungsdrähtchen (Bonddrähte) werden mittels Ultraschallschweißen auf den Kontaktflächen und den Anschlußstellen des Halbleiterbausteins fixiert. Der Halbleiterbaustein selbst kann auch durch die Weiterverarbeitung beim Kartenhersteller Schaden nehmen.

Aus diesem Grunde wird im Rahmen der Qualitätskontrolle beim Kartenhersteller sowohl die elektrische Funktionstüchtigkeit der Chipkarten als auch der Chipmodule - als Zwischenerzeugnis- überprüft. Zu diesem Zweck werden Testeinrichtungen verwendet, die die Kontaktflächen der zu testenden Chipkarte oder des zu testenden Chipmoduls mit Standardwerten für die Versorgungsspannung, für das Taktsignal etc. beaufschlagen, wobei nachgeschaut wird, ob nach dem Einschalten dieser Standardwerte von der Chipkarte oder dem Chipmodul ordnungsgemäß eine vorherbestimmte Bitfolge (der sogenannte Answer-To-Reset, "ATR") gesendet wird. Antwortet die Chipkarte oder das Chipmodul überhaupt nicht oder fehlerhaft, so wird es als defekt eingestuft. Einen Hinweis auf mögliche Fehlerquellen lieferen diese einfachen Testeinrichtungen nicht; sie liefern nur eine Gut- oder Schlecht-Information.

Aus dem HEWLETT-PACKARD Test- und Meßtechnik Hauptkatalog 1990, S. 524 -528 ist eine Einrichtung zum Testen der Funktionstüchtigkeit von kontaktbehafteten Chipkarte, die elektrische Kontaktflächen zum Betrieb und zur Kommunikation des in der in der Chipkarte angeordneten integrierten Halbleiterbausteins mit einem Chipkarten-Terrninal aufweist, wobei das Chipkarten-Terminal die Kontaktflächen mit elektrischen Signalen (Vcc, CLK, RST,I/O, GND) beaufschlagt und über mindestens eine der Kontaktflächen auch elektrische Signale (I/O) von der Chipkarte empfängt, wobei
- eine Kontaktiereinheit mit Kontaktelementen besetzt ist, die jeweils mit den korrespondierenden Kontaktflächen der Chipkarte elektrisch leitend kontaktierbar sind,
- eine elektronische Steuer- und Auswerteeinheit, mit den Kontaktelementen der Kontaktiereinheit verbunden ist, um die Kontaktflächen mit elektrischen Signalen (Vcc, CLK, RST,I/O, GND) zu beaufschlagen und von mindestens einer Kontaktfläche elektrische Signale (I/O) zu empfangen, wobei
- über die Steuer- und Auswerteeinheit wenigstens ein Parameter von mindestens einem elektrischen Signal, mit dem eine Kontaktfläche beaufschlagt wird, veränderbar ist,
- von der Steuer- und Auswerteeinheit wenigstens ein Parameter von mindestens einem elektrischen Signal zu Testzwecken gemessen wird.

Hierbei werden Kapazitäten, Gleichspannungs- und Wechsel-Spannungs- und Funktionsmessungen vorgenommen, wobei jeweils sehr aufwendig eine Strom-Spannungskennlinie gemessen und bezüglich einer Schwellspannung, einer Durchbruchspannung, eines Leckstromes ausgewertet wird. Die einzelnen Kontaktflächen werden programmgesteuert angewählt, und die Meßergebnisse werden auf einem Bildschirm zur Darstellung gebracht.

Weiterhin ist aus der EP-A-0 528 598 (NCR INT JNC) 24. Februar 1993, eine Meßvorrichtung bekannt, wobei eine Spannungs- oder Stromquelle mit einem Versorgungsanschluß eines Chips verbunden werden und eine Erdelektrode eine Referenzspannung gelegt wird und die weiteren Elektroden jeweils über einen Analogsignalschalter mit einem Analog-Digitalwandler verbunden werden, dessen Ausgangssignal einer digitalen Auswertevorrichtung zugeführt wird. Diese Testmöglichkeiten geben nur beschränkt eine Funktionsaussage, da kein dynamischer Test und kein Kurzschlußtest, ausgenommen bezüglich des Versorgungsanschlusses vorgesehen ist.

Weiterhin ist aus der US-A-5 025 344 (MALY WOJCIECH PETAL) 18. Juni 1991, eine Schaltungsanordnung bekannt, die in eine integrierte Schaltung zu integrieren ist und den Stromfluß in die Schaltung überwacht und Defekte, wie Kurzschluß und offene Schaltung ermittelt. Bei Kurzschluß oder Fehllast kann ein Unterbrecher ausgelöst werden, der den Stromfluß ausschaltet.

Aufgabe der Erfindung ist die Schaffung einer einfacheren Einrichtung zum Testen der elektrischen Funktionstüchtigkeit einer kontaktbehafteten Chipkarte, die jedoch auch eine differenzierte Fehleranalyse ermöglicht.

Diese Aufgabe wird durch die kennzeichnenden Merkmale des Patentanspruches 1 gelöst. Die sich daran anschließenden Unteransprüche enthalten vorteilhafte Ausgestaltungen der Erfindung.

Die Einrichtung weist eine elektronische Steuer- und Auswerteeinheit auf, die mit den Kontaktelementen einer Kontaktiereinheit verbunden ist, um die Kontaktflächen der Chipkarte oder des Chipmoduls mit elektrischen Signalen zu beaufschlagen und von mindestens einer Kontaktfläche elektrische Signale zu empfangen. Dabei ist die über Steuerund Auswerteeinheit wenigstens ein Parameter von mindestens einem elektrischen Signal, mit dem eine Kontaktfläche beaufschlagt wird, veränderbar. Außerdem wird von der Steuer- und Auswerteeinheit wenigstens ein Parameter von mindestens einem elektrischen Signal an einer Kontaktfläche gemessen.

Die Einrichtung kann darüber hinaus auch zum Testen von Chipmodulen eingesetzt werden, wobei lediglich die Kontaktiereinheit mechanisch entsprechend modifiziert ist.

Dadurch, daß man mit der Testeinrichtung ganz gezielt Parameter von elektrischen Signalen einstellen und Parameter von elektrischen Signalen messen kann, wird eine Fehlerdiagnose für Chipkarten und Chipmodule ermöglicht. Um möglichst genau messen zu können, sind für die verschiedenen Meßparameter unterschiedliche Meßbereiche auswählbar, die der Benutzer je nach Anforderung einstellen kann. Alternativ dazu ist es auch vorgesehen, daß die Testeinrichtung den Meßbereich automatisch z.B. bei einem Overflow eines Meßwertes im eingestellten Bereich auf den jeweils größeren Meßbereich umschaltet.

In der folgenden Tabelle wird eine Übersicht über die relevanten elektrischen Signale und deren einstellbare bzw. meßbare Parameter gegeben:

| **Elektrisches Signal** | **Parameter** |
|---|---|
| Versorgungspannung (Vcc) | Spannungswert, Strom |
| Taktfrequenz (CLK) | Frequenz, Duty-Cycle, High-Pegel, Low-Pegel, Strom |
| Datenbit auf I/O | High-Pegel zur und von der Chipkarte, Low-Pegel zur und von der Chipkarte, Strom, etu |
| Reset | High-Pegel, Low-Pegel, Strom |

So kann beispielsweise mit Hilfe der Einrichtung überprüft werden, ob die Chipkarte bzw. das Chipmodul die ISO-Spezifikationen (7816-3) hinsichtlich der elektrischen Funktionsparameter erfüllt. Damit ist beispielsweise die Frage gemeint, ob die Chipkarte tatsächlich mit allen Taktfrequenzen betrieben werden kann, die innerhalb des spezifizierten Taktfrequenzbereiches liegen; oder die Frage, ob die spezifizierten Grenzwerte für die verschiedenen High- und Low-Spannungspegel von der Chipkarte eingehalten werden; oder die Frage, ob der spezifizierte Toleranzbereich für die Versorgungsspannung von der Chipkarte eingehalten wird, oder die Frage, ob die spezifizierten Grenzwerte für die Stromaufnahme von der Chipkarte eingehalten werden. So kann mit der Einrichtung auch festgestellt werden, bei welcher Einstellung eines gewissen Parameters eines elektrischen Signals die Chipkarte nicht mehr ordnungsgemäß arbeitet. Hierdurch ist eine differenzierte Fehleranalyse ermöglicht.

Darüber hinaus kann mit der Einrichtung selektiv festgestellt werden, ob die elektrische Verbindung von einer Kontaktfläche zu der entsprechenden Anschlußstelle an dem Halbleiterbaustein einwandfrei ist. Darüber hinaus kann mit der Einrichtung selektiv festgestellt werden, ob eine bestimmte Kontaktfläche einen Kurzschluß zu einer anderen Kontaktfläche hat.

Die Einrichtung ist einsetzbar in der Chipkartenproduktion zur Qualitätskontrolle und zur Qualtitätssicherung, und zwar sowohl zum Testen von fertigen Chipkarten als auch von Chipmodulen. Darüber hinaus ist die Einrichtung als Testmittel für die Wareneingangskontrolle beim Kunden eines Kartenherstellers einsetzbar. Weiterhin ist die Einrichtung generell in Testlabors einsetzbar, die zum Beispiel Chipkarten testen, die bereits im Feld waren und vom Kunden aufgrund eines Defektes reklamiert wurden.

Anhand der beigefügten Zeichnungen ist die Vorrichtung nachfolgend näher beschrieben. Es zeigt:
- Fig.1: eine Draufsicht auf eine Chipkarte mit den Normkontaktflächen, - Stand der Technik -
- Fig.2: einen Schnitt durch eine Chipkarte im Bereich des Chipmoduls, - Stand der Technik -
- Fig.3: eine schematische Ansicht der Verbindung zwischen zwei Kontaktflächen und den Anschlußstellen am Halbleiterbaustein mit interner Schutzbeschaltung für jeden Eingang, - Stand der Technik-
- Fig.4: eine schematische Ansicht der Einrichtung,
- Fig.5: eine Meßschaltung zur Überprüfung eines Kurzschlusses der Kontaktfläche C4,
- Fig.6: eine Meßschaltung zur Überprüfung der leitenden Verbindung zwischen der Kontaktfläche C 1 und der Anschlußstelle am Halbleiterbaustein,
- Fig.7: die Ausfühnmgsform einer 1. graphischen Benutzeroberfläche,
- Fig.8: die Ausführungsform einer 2. graphischen Benutzeroberfläche,
- Fig.9: ein Blockschaltbild der erfindungsgemäßen Steuer- und Auswerteeinheit
- Fig.10: den Frequenz-Schieberegler sowie den Takt-High-Pegel-Schieberegler jeweils in zwei verschiedenen Stellungen sowie die entsprechenden Signalverläufe.

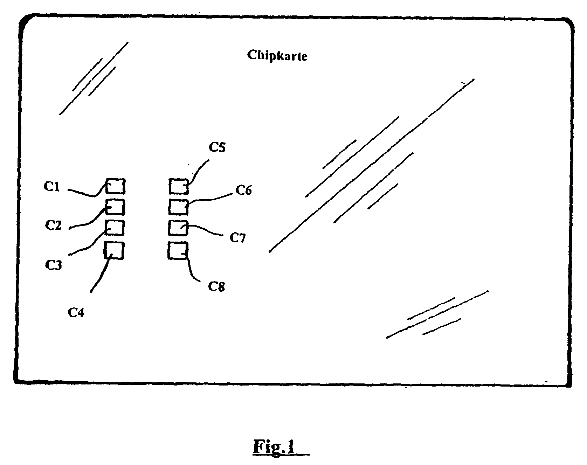

In **Figur 1** ist eine kontaktbehaftete Chipkarte mit den Kontaktflächen C1 bis C8 dargestellt. Die räumliche Anordnung und Größe dieser Kontaktflächen sowie die Belegung der Kontaktflächen ist durch die ISO-Norm 7816-2 standardisiert. Die mit C 1 bezeichnete Kontaktfläche ist für die Versorgungspannung Vcc vorgesehen, die der Chipkarte von einem Chipkarten-Terminal zugeführt wird. Typische Standardwerte für die Versogungsspannung sind 3V oder 5V. Die Kontaktfläche C2 ist für das Reset-Signal (RST) vorgesehen, das von dem Chipkartenterminal an die Chipkarte geschickt wird. Die Kontaktfläche C3 ist für das Taktsignal (CLK) vorgesehen, das von dem Chipkarten-Terminal an die Chipkarte geschickt wird. Die Kontaktflächen C4 und C8 sind für künftige Funktionsbelegungen reserviert. Die Kontaktfläche C5 ist für die Masseverbindung (GND) vorgesehen. Die Kontaktfläche C6 ist für eine Programmierspannung (Vpp) vorgesehen, die jedoch bei den heutigen Chipkarten nicht mehr benötigt wird, da diese Chipkarten die Programmierspannung intern über eine sogenannte Ladungspumpe aus der Versorgungsspannung generieren. Die Kontaktfläche C7 ist für die Datenübertragung (I/O) von dem Chipkarten-Terminal zur Chipkarte und umgekehrt vorgesehen. Hierbei handelt es sich um eine serielle, bidirektionale Datenübertragung.

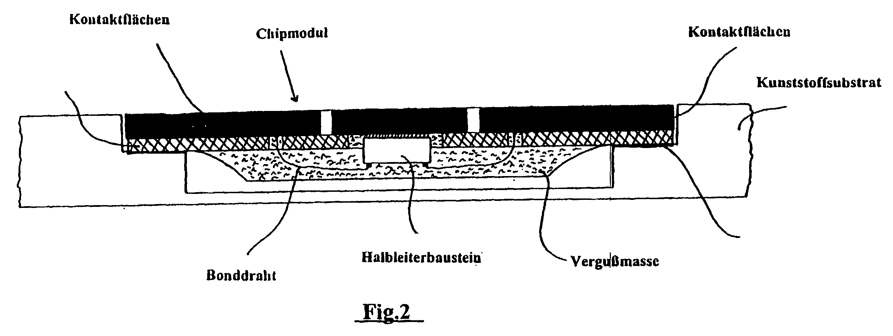

In **Figur 2** ist ein Schnitt durch eine Chipkarte im Bereich des Chipmoduls gezeigt. Das Chipmodul, welches als Trägerelement den Halbleiterbaustein und die Kontaktflächen trägt, ist in einer zweistufigen, sacklochartigen Aussparung des Kartenkörpers eingesetzt und dort mittels eines Klebers fixiert. Das Chipmodul weist ein Kunststoffsubstrat auf, auf dem die Kontaktflächen angeordnet sind. In einer Aussparung des Kunststoffsubstrats ist der Halbleiterbaustein angeordnet und mittels eines Klebers fixiert. Die Anschlußstellen des Halbleiterbausteins sind über dünne Bondrähtchen (ϕ ca. 80µm) mit den Kontaktflächen leitend verbunden. Zur Durchführung der Bonddrähtchen weist das Kunststoffsubstrat Aussparungen auf Zum Schutz des Halbleiterbausteins und der Bonddrähtchen sind diese von einer thermisch oder UV härtenden Vergußmasse umgeben.

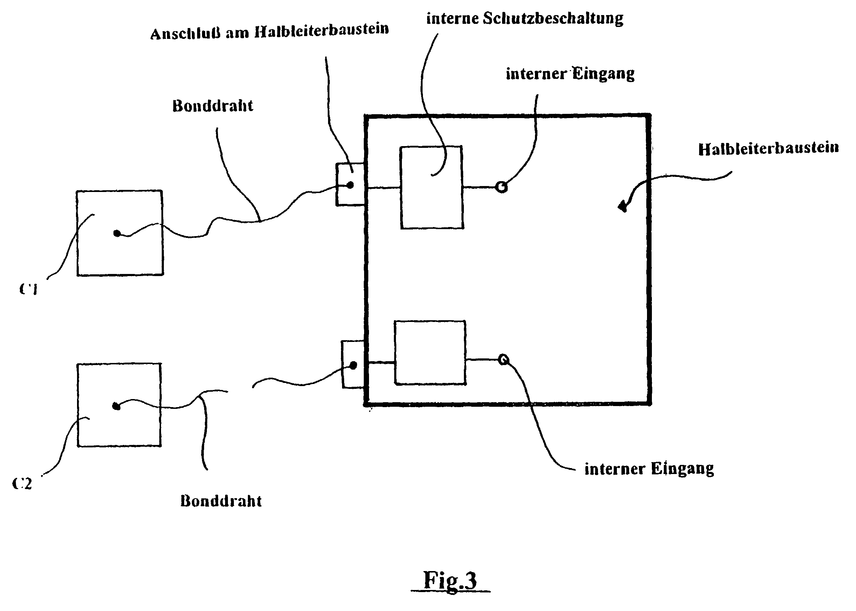

In **Figur 3** ist schematisch die Verbindung zwischen zwei Kontaktflächen C1 und C2 und den Anschlußstellen am Halbleiterbaustein gezeigt. Zum Schutz vor elektrostatischen Entladungen sind die Anschlußstellen am Halbleiterbaustein nicht direkt mit dem entsprechenden internen Eingang verbunden, sondern über eine interne Schutzbeschaltung, die aus Dioden und Widerständen besteht, dabei kann der Stromfluß über die interne Schutzbeschaltung ausgenutzt werden, um die ordnungsgemäße Verbindung zwischen der Kontaktfläche und der Anschlußstelle zu überprüfen.

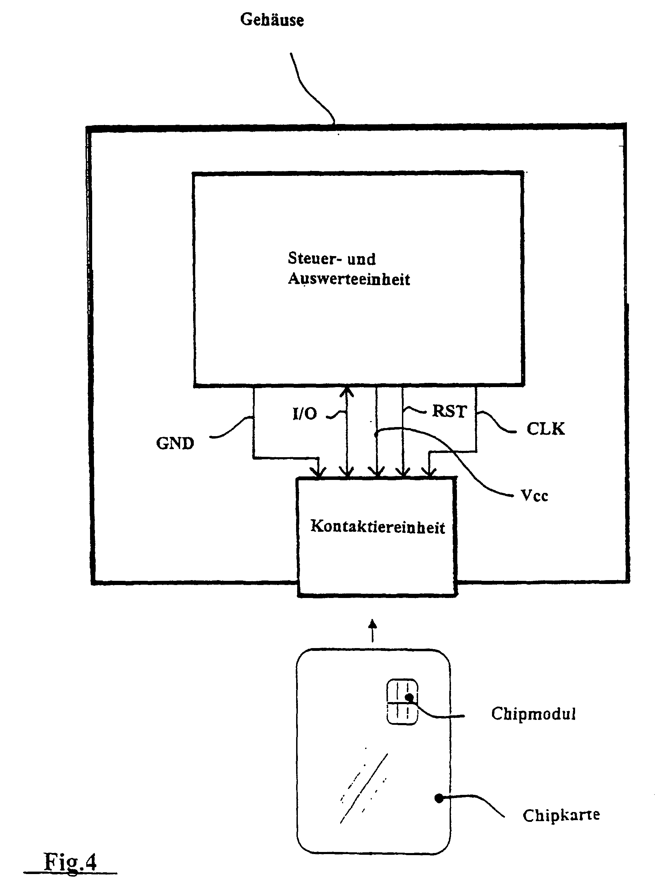

In **Figur 4** ist die erfindungsgemäße Einrichtung schematisch dargestellt. In der dort gezeigten Ausführungsform besteht sie aus einem Gehäuse, in dem die Steuer- und Auswerteeinheit und eine Kontaktiereinheit untergebracht ist. Die Kontaktiereinheit weist Kontaktelemente auf, die zu den Kontaktflächen auf der Chipkarte korrespondieren und mit diesen in Berühungskontakt gebracht werden. Die Kontaktelemente bestehen je nach Ausführungsvariante aus absenkbaren oder schleifenden Kontakten, wobei auf am Markt erhältliche Kontaktierelemente zurückgegriffen werden kann. In einer weiteren Ausführungsform ist die Kontaktiereinheit nicht in dem Gehäuse integriert, in dem die Steuer- und Auswerteeinheit untergebracht ist, sondern separart, räumlich von diesem getrennt angeordnet.

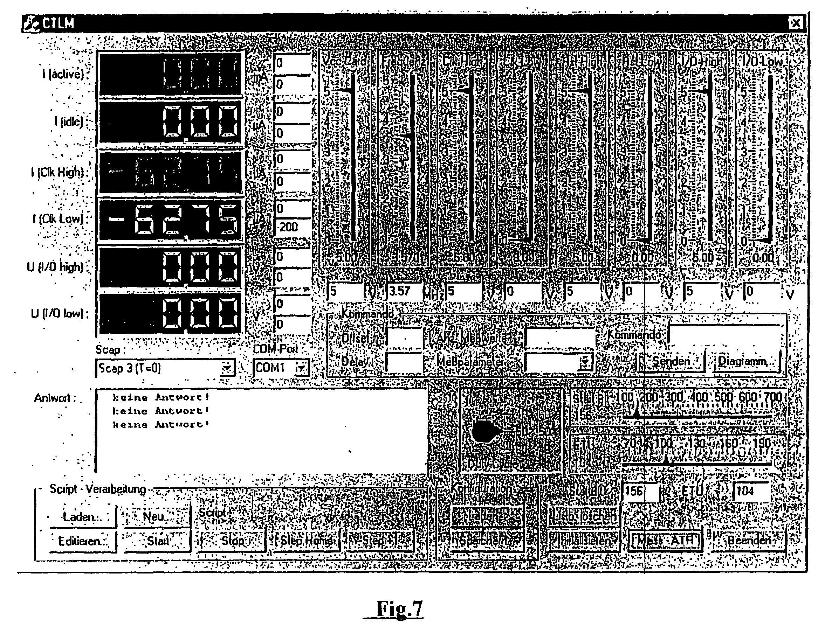

In **Figur 7** ist eine Ausführungsform für eine graphische Benutzeroberfläche für die erfindungsgemäße Testeinrichtung gezeigt. Die graphische Benutzeroberfläche wird auf einem Monitor eines Personal Computers, mit dem die Testeinrichtung über ein entsprechendes Schnittstellkabel verbunden ist, dargestellt. Die Benutzeroberfläche weist unter anderem Schieberegler (im englischen slide control" genannt) zur Einstellung der Parameter der elektrischen Signale auf, mit denen die Chipkarten-Kontaktflächen beaufschlagt werden. Zusätzlich zu den Schiebereglem weist die Benutzeroberfläche Eingabefenster zur Eingabe der Parameter der elektrischen Signale auf. Die Eingabefenster dienen gleichzeitig zur Anzeige der jeweils über die Schieberegler eingestellten Werte. Der Benutzer kann somit wahlweise die Schieberegler oder die Eingabefenster benutzen, wobei dem Benutzer auch bei der Betätigung der Schieberegler der jeweils aktuelle Wert in dem Eingabefenster angezeigt wird. Darüber hinaus verfügt die Benutzeroberfläche über Ausgabefenster zur Anzeige von gemessenen Parameterwerten als Zahlenwert, bspw. dem Strom auf der Vcc-Leitung.

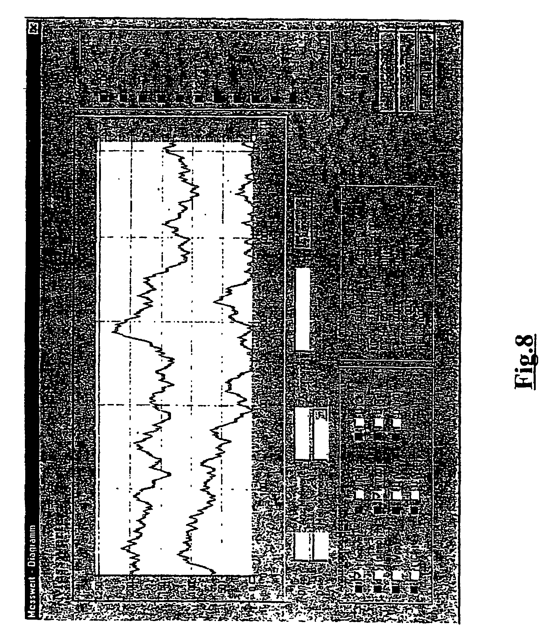

In **Figur 8** ist eine alternative Ausführungsform für die graphische Benutzeroberfläche dargestellt. In dieser Ausführungsform ist es möglich, den zeitlichen Verlauf von gemessenen Parameterwerten graphisch darzustellen - ähnlich einem Oszilloskop. Welche der gemessenen Parameterwerte auf diese Art angezeigt werden sollen, kann der Benutzer über die Aktivierung ("Anklicken") von entsprechenden Auswahlfenster bestimmen.

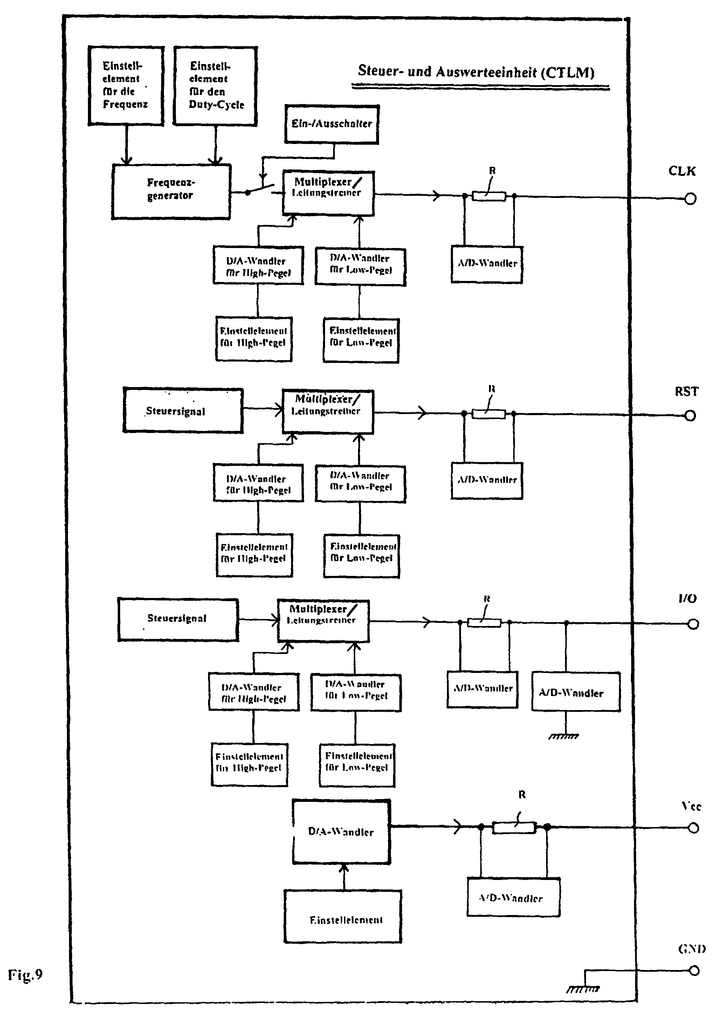

In **Figur 9** ist ein Blockschaltbild der erfindungsgemäßen Steuer- und Auswerteeinheit dargestellt, welches nachfolgend näher erläuter werden soll:

Die Steuer- und Auswerteeinheit weist einen einstellbaren Frequenzgenerator auf, um ein hinsichtlich der Frequenz variables Taktsignal (CLK) an die Chipkarte senden zu können. Der einstellbare Frequenzbereich liegt zwischen 1MHz und 5MHz, womit der gesamte von der ISO-Norm zulässige Bereich abgedeckt wird. Zur Einstellung der Frequenz ist ein Einstellelement vorgesehen. Das Einstellelement ist vorzugsweise ein entsprechender Schieberegler bzw. das korrespondierende Eingabefenster auf der Benutzeroberfläche. Beim dem einstellbaren Frequenzgenerator kann der Fachmann auf bekannte Komponenten (PLL-Schaltung - Phase Lock Loop) zurückgreifen. Als Frequenznormal für die PLL-Schaltung dient dabei ein Schwingquarz mit einer festen Frequenz. Der Ausgang des Frequenzgenerators geht als Umschaltsignal auf einen Multiplexer, der gleichzeitig als Leitungstreiber fungiert. Der Ausgang des Multiplexers ist dem entsprechenden Kontaktelement für das Taktsignal innerhalb der Kontaktiereinheit zugeführt. Der Multiplexer schaltet zwischen einem einstellbaren High-Spannungspegel und einem einstellbaren Low-Spannungspegel um - getriggert durch das Ausgangssignal des Frequenzgenerators. Auf diese Weise wird nicht nur ein Taktsignal mit veränderlicher Frequenz zur Verfügung gestellt, darüber hinaus können auch noch der High-Pegel und der Low-Pegel des Taktsignals unabhängig voneinander eingestellt werden. Zur Einstellung dieser Spannungspegel ist jeweils ein Digital-/Analog-Wandler vorgesehen, desssen analoger Ausgangswert über ein digitales Einstellelement (z.B. Schieberegler auf der Benutzeroberfläche) vorgegeben wird. Anstatt über Digital-/Analog-Wandler kann die Einstellung auch über Spannungspotentiometer erfolgen.

Für das ordnungsgemäße Funktionieren der Chipkarten ist auch der "Duty-Cycle" von entscheidender Bedeutung. Hierunter versteht man das Verhältnis der High-Pegel-Zeit zur Low-Pegel-Zeit innerhalb der Periodendauer. Normalerweise sollten die Chipkarten mit einem symmetrischen "Duty-Cycle" von 50%- 50% betrieben werden, d.h. die High-Pegelzeit ist gleich der Low-Pegelzeit. Da die von den Chipkarten-Terminals generierten Taktsignale jedoch nicht immer einen sauberen "Duty-Cycle" von 50%-50% aufweisen, sondern die "Duty-Cycle" der Chipkarten-Terminals bekanntermaßen aus den verschiedensten Gründen von dem Idealwert 50%-50% abweichen, sind die Halbleiterbausteine in den Chipkarten bereits so ausgelegt, daß sie "Duty-Cycle" innerhalb eines bestimmten Toleranzbereiches (z.B. 40%-60% bzw. 60%-40%) akzeptieren. Aus diesem Grunde ist es sehr wichtig, zu testen, ob eine Chipkarte auch tatsächlich in der Lage ist, innerhalb dieses Toleranzbereiches zu arbeiten. Die Durchführung dieses Test ist mit der erfindungsgemäßen Einrichtung ebenfalls möglich. Zu diesem Zweck können mit der Testeinrichtung gezielt bestimmte "Duty-Cycle" genau eingestellt werden. Die Einstellung des "Duty-Cycle" wird erfindungsgemäß folgendermaßen realisiert: Von der PLL-Schaltung des Frequenzgenerators wird eine Frequenz erzeugt, die einem ganzzahligen Vielfachen der Frequenz entspricht, die der Benutzer über den CLK-Schieberegler als Taktfrequenz eingestellt hat (f_{PLL} = X * f_{CLK}). Die Ausgangsfrequenz der PLL-Schaltung wird dann auf einen Frequenzteiler gegeben, der entweder auf die positiven oder die negativen Flanken der PLL-Ausgangsfrequenz reagiert. Dabei geht der Ausgang des Frequenzteilers jeweils nach n-Flanken auf High, anschließend nach (X-n) Flanken wieder auf Low, anschließend nach n-Flanken wieder auf High usw. Der eingestellte "Duty-Cycle" ist dann n/(x-n). Dadurch, daß der Frequenzteiler so ausgelegt ist, daß er nur auf die positive oder nur auf die negative Flanke reagiert, kann auch dann ein exakter "Duty-Cycle" eingestellt werden, wenn der "Duty-Cycle" der PLL-Ausgangsfrequenz nicht genau symmetrisch ist. Falls der "Duty-Cycle" der PLL als Mutteroszillator an sich nicht symmetrisch ist, ist es auch vorgesehen, die Ausgansfrequenz des PLL zu halbieren, um eine Frequenz mit einem symmetrischen "Duty-Cycle" als Ausgangsbasis zu erhalten. Der nachfolgende Frequenzteiler zur Erzeugung eines definiert unsymmetrischen "Duty-Cycle" kann dann sowohl auf negative wie auf positive Flanken reagieren.

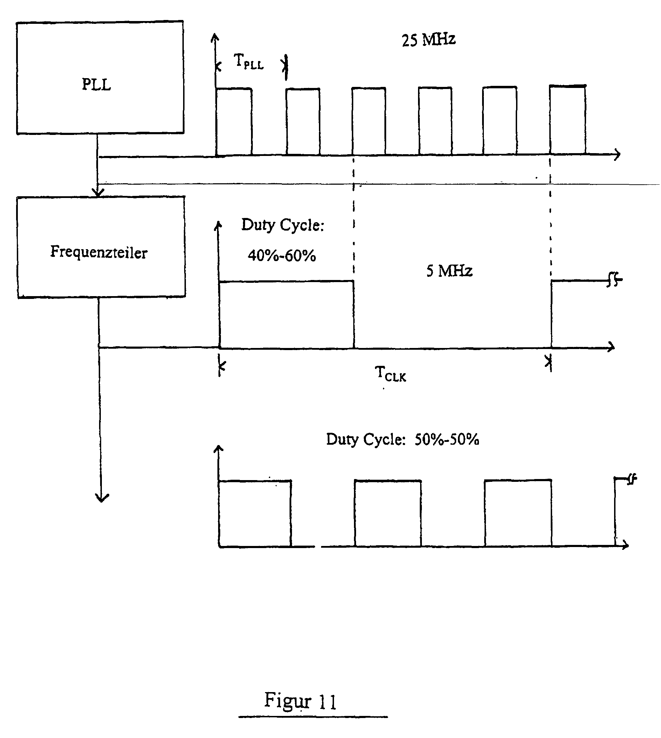

An einem Beispiel (siehe **Figur 11**) soll die "Duty-Cycle"-Einstellung erläutert werden. Der Benutzer habe am CLK-Schieberegler eine Frequenz von 5 MHz eingestellt; außerdem wünscht er einen "Duty-Cycle" von 40%- 60%. In diesem Fall erzeugt die PLL eine fünffach höhere als die gewünschte, d.h. eine Frequenz von 25 MHz, die dann auf den Frequenzteiler gegeben wird. Dieser ist so ausgelegt, daß sein Ausgang nach drei positiven Flanken von Low nach High wechselt und nach weiteren zwei positiven Flanken wieder von High nach Low wechselt usw. Zur Erzeugung eines "Duty-Cycle" von 40%- 60% bzw. 60%-40% (2/3 bzw. 3/2) wird von der PLL immer eine fünfach höhere Frequenz als die gewünschte erzeugt, da der Faktor 5 gleich der Summe der Quotienten (2 und 3) des "Duty-Cycle" ist.

Um eine Taktfrequenz von 5MHz bei einem "Duty-Cycle" von 50%- 50% einzustellen, erzeugt die PLL eine vierfach höhere Frequenz als die gewünschte, d.h. eine Frequenz von 20MHz (nicht dargestellt), die dann auf den Frequenzteiler gegeben wird. Dieser ist dann so ausgelegt, daß sein Ausgang nach zwei positiven Flanken von Low nach High wechselt und nach weiteren zwei Flanken wieder von High nach Low wechselt usw. Um einen symmetrischen "Duty-Cycle" zu erzeugen, ist der Faktor 4 für die von der PLL zu erzeugende Frequenz vorteilhaft, da dann diese Frequenz größenordnungsmäßig in demselben Bereich liegt, wie im Falle des unsymmetrischen "Duty-Cycle".

Die Einstellung des "Duty-Cycle" erfolgt über einen Drehschalter auf der Benutzeroberfläche.

Ein weiteres Merkmal der erfindungsgemäßen Testeinrichtung ist, daß der Strom, der auf der CLK-Leitung zur entsprechenden Chipkarten-Kontaktfläche fließt, gemessen werden kann. Hierzu ist ein Meßwiderstand vorgesehen, wobei der Spannungsabfall an diesem Meßwiderstand mittels eines Analog-/Digital-Wandlers gemessen wird. Dabei wird der digitale Ausgangswert über dem Fachmann bekannte Hardeware-Komponenten auf der graphischen Benutzeroberfläche zur Anzeige gebracht.

Außerdem weist die Steuer- und Auswerteeinheit Mittel zum Einstellen des Versorgungsspannungs-Signals (Vcc) auf. Diese Mittel bestehen vorzugsweise aus einem Digital-/Analog-Wandler, der über den Vcc-Schieberegler auf der Benutzeroberfläche einstellbar ist. Alternativ können die Mittel zur Einstellung der Versorgungsspannung auch von einem Spannungspotentiometer gebildet sein. Ferner weist die Steuer- und Auswerteeinheit Mittel zur Messsung des Stroms auf, der zu oder von der Chipkarten-Köntaktfläche für die Versorgungsspannung fließt. Vorzugsweise wird hierfür ein Analog-/Digital-Wandler verwendet, der zur Strommessung den Spannungsabfall an einem Meßwiderstand in ein digitales Signal wandelt.

Außerdem ist es mit der erfinungsgemäßen Einrichtung möglich, den High-Spannungspegel und den Low-Spannungspegel der Datenbits, die auf der I/O-Leitung an die Chipkarte gesendet werden, einzustellen. Für diesen Zweck ist wiederum je ein Digital-/Analog-Wandler vorgesehen, der jeweils über Schieberegler auf der Benutzeroberfläche eingestellt wird. Zur Generierung der Datenbits ist ein Mulitplexer vorgesehen, der in Abhängigkeit von einem Steuersignal, das bspw. vom Personal Computer geschickt wird, zwischen den beiden Digital-/Analog-Wandlern umschaltet. Anstatt von Digital-/Analog-Wandlern können auch Spannungspotentiometer für die Einstellung der Pegel verwendet werden.

Die Datenübertragungsrate wird durch die Frequenz des Steuersignals bestimmt, das den Mulitplexer ansteuert. Dabei ist die Datenübertragungsrate (Baudrate) über einen einstellbaren Teilerfaktor mit der Taktfrequenz korreliert. Innerhalb der Chipkarte wird die Datenübertragungsrate auf diese Weise aus dem Taktsignal abgeleitet. Dies kann z.B. durch eine programmierte Warteschleife sein, die entsprechend dem Wert des Teilerfaktors mehrmals durchlaufen wird. Dabei gilt folgende Beziehung: Baudrate = Taktfrequenz/Teilerfaktor. Die Länge eines Datenbits (etu: elementary time unit) ist gleich dem Kehrwert der Baudrate. Typische Daten für den Betrieb einer Chipkarte in einem Standard-Chipkartenterminal sind bspw. eine Taktfrequenz von 3,5712 MHz und ein Teilerfaktor von 372. Damit ergibt sich eine Baudrate von 9600 Bit/s. Viele Chipkarten sind jedoch in der Lage, auch andere Teilerfaktoren zu unterstützen. Je kleiner der Teilerfaktor, desto größer die Datenübertragungsrate. Die erfindungsgemäße Testeinrichtung ist ebenfalls in der Lage, verschiedene Datenübertragungsraten bzw. etu-Werte einzustellen. Hierfür ist ein etu-Schieberegler auf der Benutzeroberfläche vorgesehen.

Die erfindungsgemäße Einrichtung ist außerdem in der Lage, den Strom auf der I/O-Leitung zu messen. Zu diesem Zweck ist ein Analog-/Digital-Wandler vorgesehen, der zur Strommessung den Spannungsabfall an einem Meßwiderstand mißt und in ein digitales Signal wandelt.

Ferner ist die erfindungsgemäße Testeinrichtung in der Lage, die Spannungspegel auf der I/O-Leitung zu messen, um zu überprüfen, ob die High- bzw. Low-Pegel der von der Chipkarte gesendeten Datenbits innerhalb der erlaubten Bereich liegen. Zu diesem Zweck weist die Steuer- und Auswerteeinheit einen Analog-/Digital-Wandler auf, der die Spannungsdifferenz zwischen der I/O-Leitung und der Referenzspannung (Masse) in ein digitales Signal wandelt.

Die erfindungsgemäße Testeinrichtung ist außerdem in der Lage, den High- und Low-Pegel des Resetsignals (RST) einzustellen. Hierfür schaltet ebenfalls ein Multiplexer in Abhängigkeit von einem Steuersignal zwischen zwei den Ausgängen von zwei Digital/Analog-Wandlern um, die über entsprechende Schieberegler (RST-High, RST-Low) auf der Benutzeroberfläche einstellbar sind. Auch hier kann die Einstellung alternativ über Spannungspotentiometer erfolgen.

Zur Messung des Stroms auf der Resetleitung ist ein Analog-/Digital-Wandler vorgesehen, der zur Strommessung den Spannungsabfall an einem Meßwiderstand mißt. Darüber hinaus ist es auch vorgesehen (nicht dargestellt) über einen Analog-/Digital-Wandler die Spannung auf der Resetleitung gegenüber der Referenzspannung zu messen.

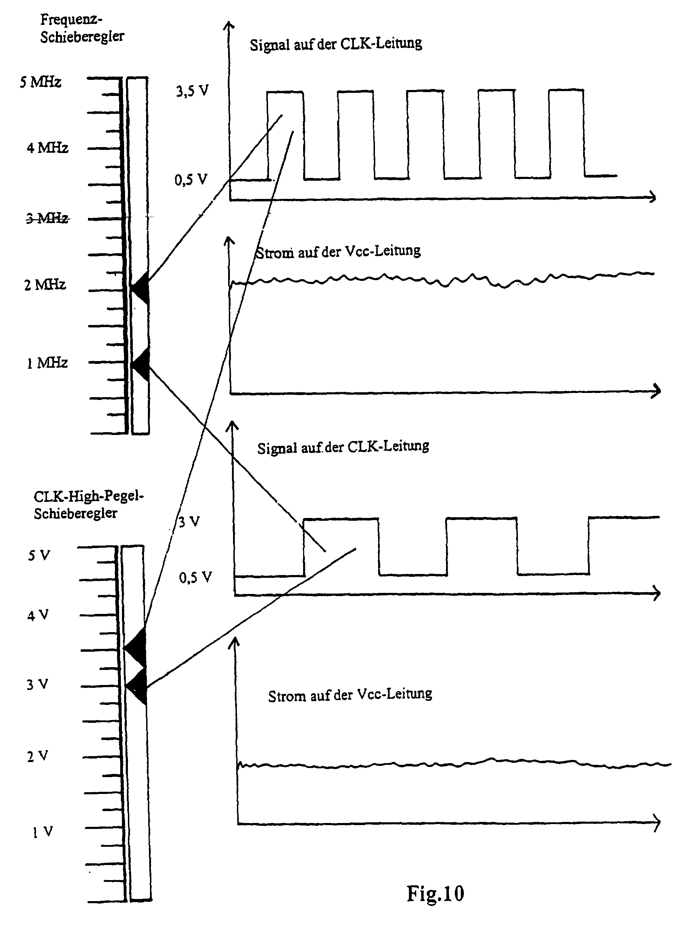

Ein Einstellungs- und Meßszenario ist auf **Figur 10** dargestellt. Dargestellt ist einmal das über die Schieberegler eingestellte Taktsignal und zum anderen der gleichzeitig gemessene Strom auf der Vcc-Leitung. In der oberen Hälfte der Figur ist der Fall dargestellt, wo eine Frequenz von 2MHz mit einem ein High-Pegel von 3,5V und einem Low-Pegel von 0,5V eingestellt wurde. In der unteren Hälfte der Figur war die Einstellung die folgende: Frequenz: 1 MHz, High-Pegel 3V und Low-Pegel 0,5V. Der Stromaufnahme des Halbleiterbausteins im Falle der höheren Frequenz ist erwartungsgemäß höher (nicht maßstabsgerechte Darstellung).

Ein Basistest mit der Einrichtung besteht darin, nach der Aktivierung der Chipkarte mit den eingestellten Parametern eine von der Chipkarte gesendete, vorherbestimmte Bitfolge (den sogenannten Answer-To-Reset, ATR) auszulesen. Der Benutzer kann nun die verschiedensten Einstellungen wählen und jeweils nachschauen, ob der ordnungsgemäße ATR noch kommt und bei welcher Einstellung er nicht mehr kommt. Dabei wird während der ATR ausgelesen wird vorzugsweise standardmäßig der High-und der Low-Pegel der von der Chipkarte gesendeten Datenbits gemessen. Wann nach der Aktivierung der Chipkarte mit der Messung begonnen wird, und wie oft und in welchen Zeitabständen gemessen wird, kann ebenfalls festgelegt werden. Zur Festlegung des Startzeitpunktes weist die Benutzeroberfläche einen StartBit-Zeit-Schieberegler auf.
Dies gilt generell für alle Meßparameter. In einer ersten Ausführungsform wird jedes Datenbit des ATR abgetastet (Messung der Pegelwerte), dabei können die einzelnen Meßwerte abgespeichert und ggf. angezeigt werden, oder es wird ein Mittelwert gebildet, der dann abgespeichert und angezeigt wird. In einer alternativen Ausführungsform werden nur einzelne Datenbits des ATR abgetastet; auch hier kann wieder eine Mittelwertbildung erfolgen. Gleichzeitig wird während der ATR-Messung der Strom auf der Vcc-Leitung gemessen. Im Anschluß an den ATR wird ebenfalls der Strom auf der Vcc-Leitung gemessen, der wesentlich niedriger sein sollte, da die Chipkarte sich dann in einem sogenannten Ruhemodus befindet.

Mit der Testeinrichtung kann vorzugsweise für mindestens einen Meßparameter ein unterer und oberer Grenzwert eingestellt werden, wobei automatisch festgestellt wird, ob der gemessene Parameter innerhalb des eingestellten, erlaubten Bereiches liegt. Dabei erfolgt vorzugsweise eine optische und/oder akustische Mitteilung, ob der gemessene Wert für diesen Parameter innerhalb oder außerhalb des eingestellten, erlaubten Bereiches liegt. In einer Ausführungsform ist eine optische Mitteilung in der Form vorgesehen, daß der Meßwert grün angezeigt wird, wenn er im erlaubten Bereich liegt und rot, wenn er außerhalb liegt. So kann der Benutzer nach dem oben beschriebenen Basistest in einfacher Weise bspw. feststellen, ob die Pegelwerte der von der Chipkarte gesendeten Datenbits und der Stromverbrauch auf der Vcc-Leitung innerhalb des erlaubten Bereiches liegen.

Weitere Basistests, die mit der Einrichtung durchführbar sind, sind sogenannte Open/Short Messungen. Dabei soll festgestellt werden, ob eine Kontaktfläche auch tatsächlich mit der entsprechenden Anschlußstelle am Halbleitebaustein elektrisch leitend verbunden ist und ob eine Kontaktfläche eventuell mit einer anderen Kontaktfläche elektrisch kurzgeschlossen ist.

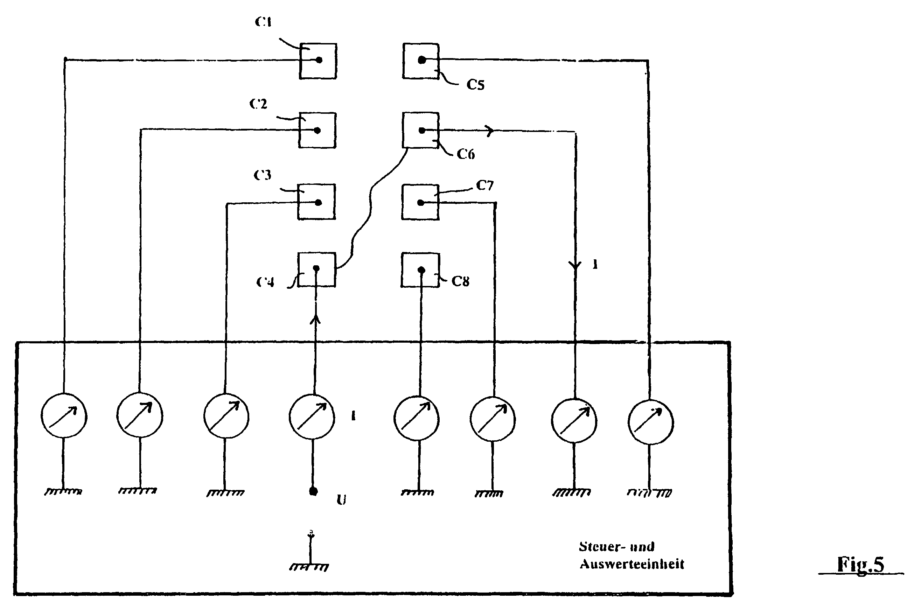

Zur Überprüfung eines Kurzschlusses von einer Kontaktfläche zu mindestens einer weiteren Kontaktfläche wird von der Steuer- und Auswerteeinheit, die zu testende Kontaktfläche auf einen 1. Spannungswert gelegt, und mindestens eine weitere Kontaktfläche auf einen 2. Spannungswert gelegt wird, wobei von der Steuer- und Auswerteeinheit mindestens der Strom zu oder von der zu testenden Kontaktfläche gemessen wird- vgl. **Figur 5**, wo alle Kontaktflächen außer C4 über ein Strommessgerät auf Masse gelegt sind.

Alternativ (nicht dargestellt) wird zur Überprüfung eines Kurzschlusses von einer Kontaktfläche zu mindestens einer weiteren Kontaktfläche von der Steuer- und Auswerteeinheit, die zu testende Kontaktfläche auf einen 1. Spannungswert gelegt, und mindestens eine weitere Kontaktfläche auf einen 2. Spannungswert gelegt wird, wobei von der Steuer- und Auswerteeinheit mindestens die Spannung auf der zu testenden Kontaktfläche gemessen wird.

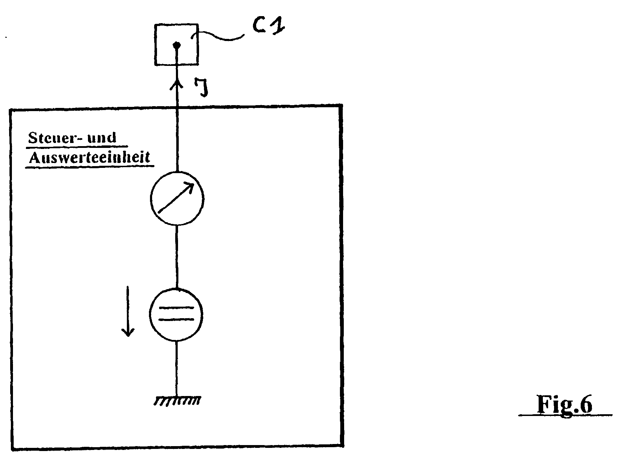

Zur Überprüfung einer einwandfreien elektrischen Verbindung von einer Kontaktfläche zu der entsprechenden Anschlußstelle an dem integrierten Halbleiterbaustein wird die zu testende Kontaktfläche von der Steuer- und Auswerteeinheit mit einer von der Referenzspannung verschiedenen Spannung beaufschlagt, wobei von der Steuer- und Auswerteeinheit der Strom zu oder von der zu testenden Kontaktfläche gemessen wird- vgl. **Figur 6**. Dabei wird die zu testende Kontaktfläche nacheinander mit mindestens zwei unterschiedlichen Spannungen beaufschlagt, wobei jeweils der Strom gemessen wird. Vorzugsweise wird die Kontaktfläche einmal mit einer Spannung beaufschlagt, die größer als die Referenzspannung ist, und einmal mit einer Spannung die kleiner als die Referenzspannung ist. Darüber hinaus ist es vorgesehen, die Spannung ausgehend von einem Startwert sukzessive zu verändern, wobei der Strom und/oder der Stromanstieg gemessen wird. Außerdem kann die Änderungsgeschwindigkeit der Spannung eingestellt werden.

Zur Testeinrichtung gehört auch ein Programm, das bereits feste Testkommandos aufweist, die der Benutzer aufrufen kann. Er kann diese Basistestkommandos jedoch auch nach Belieben zu einem spezifischen Testszenario kombinieren oder neue Testkommandos hinzufügen. Ein solches Basistestkommando ist bspw. die Strommessung auf der Taktsignal-Leitung während diese Leitung konstant auf einem bestimmten High-Pegel oder Low-Pegel liegt.

Abschließend soll noch angeführt werden, daß die Testeinrichtung verschiedene Datenübertragungsprotokolle unterstützt (T=0, T=1, T=14).

Die Testeinrichtung ist quasi ein Gerät zur Simulation von Chipkarten-Terminals, wobei mit ihr überprüft werden kann, ob eine bestimmte Chipkarte die verschiedenstens simulierten Anforderungsprofile erfüllen kann.

## Patentansprüche

1. Einrichtung zum Testen der Funktionstüchtigkeit von kontaktbehafteten Chipkarte, die elektrische Kontaktflächen zum Betrieb und zur Kommunikation des in der in der Chipkarte angeordneten integrierten Halbleiterbausteins mit einem Chipkarten-Terminal aufweist, wobei das Chipkarten-Terminal die Kontaktflächen mit elektrischen Signalen (Vcc, CLK, RST,I/O, GND) beaufschlagt und über mindestens eine der Kontaktflächen auch elektrische Signale (I/O) von der Chipkarte empfängt, wobei
- eine Kontaktiereinheit mit Kontaktelementen besetzt ist, die jeweils mit den korrespondierenden Kontaktflächen der Chipkarte elektrisch leitend kontaktierbar sind,
- eine elektronische Steuer- und Auswerteeinheit, mit den Kontaktelementen der Kontaktiereinheit verbunden ist, um die Kontaktflächen mit elektrischen Signalen (Vcc, CLK, RST,I/O, GND) zu beaufschlagen und von mindestens einer Kontaktfläche elektrische Signale (I/O) zu empfangen, wobei
- über die Steuer- und Auswerteeinheit wenigstens ein Parameter von mindestens einem elektrischen Signal, mit dem eine Kontaktfläche beaufschlagt wird, veränderbar ist,
- von der Steuer- und Auswerteeinheit wenigstens ein Parameter von mindestens einem elektrischen Signal zu Testzwecken gemessen wird, **dadurch gekennzeichnet**, zur Strommessung einen Analog-Digital-Wandler aufweist, der zur Strommessung den Spannungsabfall an einem Meßwiderstand in ein digitales Signal wandelt,
- und zur Überprüfung eines Kurzschlusses von einer Kontaktfläche zu mindestens einer weiteren Kontaktfläche von der Steuer- und Auswerteeinheit, die zu testende Kontaktfläche auf einen 1. Spannungswert gelegt wird, und mindestens eine weitere Kontaktfläche auf einen 2. Spannungswert gelegt wird, wobei von der Steuer- und Auswerteeinheit mindestens der Strom zu oder von der zu testenden Kontaktfläche und/oder mindestens die Spannung auf der zu testenden Kontaktfläche gemessen wird.

2. Einrichtung nach Anspruch 1, **dadurch gekennzeichnet, daß** zur Überprüfung einer einwandfreien elektrischen Verbindung von einer Kontaktfläche zu der entsprechenden Anschlußstelle an dem integrierten Halbleiterbaustein die zu testende Kontaktfläche von der Steuer- und Auswerteeinheit mit einer von einer Referenzspannung verschiedenen Spannung beaufschlagt wird, wobei von der Steuer- und Auswerteeinheit der Strom zu oder von der zu testenden Kontaktfläche gemessen wird.

3. Einrichtung nach Anspruch 2, **dadurch gekennzeichnet, daß** die zu testende Kontaktfläche nacheinander mit mindestens zwei unterschiedlichen Spannungen beaufschlagt wird, wobei jeweils der Strom zu oder von der zu testenden Kontaktfläche gemessen wird.

4. Einrichtung nach Anspruch 3, **dadurch gekennzeichnet, daß** die zu testende Kontaktfläche mindestens einmal mit einer Spannung beaufschlagt wird, die größer ist als die Referenzspannung, und mindestens einmal mit einer Spannung beaufschlagt wird, die kleiner als die Referenzspannung ist, wobei jeweils der Strom zu oder von der zu testenden Kontaktfläche gemessen wird.

5. Einrichtung nach einem der vorstehenden Ansprüche 2 bis 4, **dadurch gekennzeichnet, daß** die Spannung ausgehend von einem Startwert sukzessive verändert (erhöht oder erniedrigt) wird, wobei der Strom und/oder der Stromanstieg gemessen wird/werden.

6. Einrichtung nach Anspruch 5, **dadurch gekennzeichnet, daß** die Geschwindigkeit, mit der die Spannung geändert wird, einstellbar ist.

7. Einrichtung nach Anspruch 1, **dadurch gekennzeichnet, daß** zur Überprüfung einer einwandfreien elektrischen Verbindung von einer Kontaktfläche zu der entsprechenden Anschlußstelle an dem integrierten Halbleiterbaustein auf die zu testende Kontaktfläche ein Strom eingeprägt wird.

8. Einrichtung nach einem der vorstehenden Ansprüche, **dadurch gekennzeichnet, daß** nach einer Aktivierung der Chipkarte eine von der Chipkarte gesendete, vorherbestimmte Bitfolge (Anwer-To-Reset, ATR) von der Steuer- und Auswerteeinheit ausgelesen wird.

9. Einrichtung nach einem der vorstehenden Ansprüche, **dadurch gekennzeichnet, daß** dieselbe Mittel zum Einstellen eines Versorgungsspannung-Signals (Vcc) für die Chipkarte aufweist.

10. Einrichtung nach Anspruch 9, **dadurch gekennzeichnet, daß** dieselbe einen Digital-/Analog-Wandler oder ein Spannungspotentiometer zur Einstellung des Versorgungsspannung-Signals (Vcc) aufweist.

11. Einrichtung nach einem der vorstehenden Ansprüche, **dadurch gekennzeichnet, daß** dieselbe Mittel zur Einstellung eines High-Spannungspegels von zu sendenden Informationsbits aufweist, die auf die I/O-Kontaktfläche gesendet werden.

12. Einrichtung nach Anspruch 11, **dadurch gekennzeichnet, daß** dieselbe einen Digital-/Analog-Wandler oder ein Spannungspotentiometer zur Einstellung des Highspannungspegels aufweist.

13. Einrichtung nach einem der vorstehenden Ansprüche, **dadurch gekennzeichnet, daß** dieselbe Mittel zur Einstellung eines Low-Spannungspegels von zu sendenden Informationsbits aufweist, die auf die I/O-Kontaktfläche gesendet werden.

14. Einrichtung nach Anspruch 13, **dadurch gekennzeichnet, daß** dieselbe einen dieselbe einen Digital-/Analog-Wandler oder ein Spannungspotentiometer zur Einstellung des Low-Spannungspegels aufweist.

15. Einrichtung nach einem der vorstehenden Ansprüche, **dadurch gekennzeichnet, daß** dieselbe einen einstellbaren Frequenzgenerator für ein an eine der Kontaktflächen zu sendende Taktsignal (CLK) aufweist.

16. Einrichtung nach Anspruch 15, **dadurch gekennzeichnet, daß** dieselbe Mittel zur Veränderung eines Verhältnisses ("Duty Cycle") einer High-Pegel-Zeit zu einer Low-Pegel-Zeit innerhalb einer Periodendauer des zu sendenden Taktsignals (CLK) aufweist.

17. Einrichtung nach Anspruch 16, **dadurch gekennzeichnet, daß** dieselbe Mittel zur Einstellung des High-Spannungspegels des zu sendenden Taktsignals (CLK) aufweist.

18. Einrichtung nach Anspruch 17, **dadurch gekennzeichnet, daß** dieselbe einen Digital/Analog-Wandler oder ein Spannungspotentiometer zur Einstellung des High-Spannungspegels aufweist.

19. Einrichtung nach Anspruch 16, **dadurch gekennzeichnet, daß** dieselbe Mittel zur Einstellung des Low-Spannungspegels des zu sendenden Taktsignals (CLK) aufweist.

20. Einrichtung nach Anspruch 19, **dadurch gekennzeichnet, daß** dieselbe einen Digital-/Analog-Wandler oder ein Spannungspotentiometer zur Einstellung des Low-Spannungspegels aufweist.

21. Einrichtung nach einem der vorstehenden Ansprüche, **dadurch gekennzeichnet, daß** dieselbe Mittel zur Einstellung einer High-Spannungspegels eines an eine der Kontaktflächen zu sendenden Resetsignals (RST) aufweist.

22. Einrichtung nach Anspruch 21, **dadurch gekennzeichnet, daß** dieselbe einen Digital-/Analog-Wandler oder ein Spannungspotentiometer zur Einstellung des High-Spannungspegels aufweist.

23. Einrichtung nach einem der vorstehenden Ansprüche, **dadurch gekennzeichnet, daß** dieselbe Mittel zur Einstellung eines Low-Spannungspegels eines an eine der Kontaktflächen zu sendenden Resetsignals (RST) aufweist.

24. Einrichtung nach Anspruch 23, **dadurch gekennzeichnet, daß** dieselbe einen Digital-/Analog-Wandler oder ein Spannungspotentiometer zur Einstellung des Low-Spannungspegels aufweist.

25. Einrichtung nach einem der vorstehenden Ansprüche, **dadurch gekennzeichnet, daß** dieselbe Mittel zur Messung des Stroms aufweist, der zu oder von der Chipkarten-Kontaktfläche für die Versorgungsspannung (Vcc) fließt.

26. Einrichtung nach einem der vorstehenden Ansprüche, **dadurch gekennzeichnet, daß** dieselbe Mittel zur Messung des Stroms aufweist, der zu oder von der Chipkarten-Kontaktfläche für den Datenaustausch (I/O) fließt.

27. Einrichtung nach einem der vorstehenden Ansprüche, **dadurch gekennzeichnet, daß** dieselbe Mittel zur Messung einer Spannungsdifferenz zwischen der Chipkarten-Kontaktfläche für den Datenaustausch (I/O) und einer Referenzspannung aufweist.

28. Einrichtung nach Anspruch 27, **dadurch gekennzeichnet, daß** dieselbe zur Messung der Spannungsdifferenz einen Analog-/Digital-Wandler aufweist.

29. Einrichtung nach einem der vorstehenden Ansprüche, **dadurch gekennzeichnet, daß** dieselbe Mittel zur Messung des Stroms aufweist, der zu oder von der Chipkarten-Kontaktfläche für das Resetsignal (RST) fließt.

30. Einrichtung nach einem der vorstehenden Ansprüche, **dadurch gekennzeichnet, daß** dieselbe Mittel zur Messung einer Spannungsdifferenz zwischen der Chipkarten-Kontaktfläche für das Resetsignal (RST) und einer Referenzspannung aufweist.

31. Einrichtung nach Anspruch 30, **dadurch gekennzeichnet, daß** dieselbe zur Messung der Spannungsdifferenz einen Analog-/Digital-Wandler aufweist.

32. Einrichtung nach einem der vorstehenden Ansprüche, **dadurch gekennzeichnet, daß** dieselbe Mittel zur Messung des Stroms aufweist, der zu oder von der Chipkarten-Kontaktfläche für das Taktsignal (CLK) fließt.

33. Einrichtung nach einem der vorstehenden Ansprüche, **dadurch gekennzeichnet, daß** dieselbe Mittel aufweist, um eine Datenübertragungsrate für das Senden von Daten zur Kontaktfläche für den Datenaustausch (I/O) einzustellen.

34. Einrichtung nach einem der vorstehenden Ansprüche, **dadurch gekennzeichnet, daß** dieselbe Mittel aufweist, um die Datenempfangsrate für das Empfangen von Daten von der Kontaktfläche für den Datenaustausch (I/O) einzustellen.

35. Einrichtung nach einem der vorstehenden Ansprüche, **dadurch gekennzeichnet, daß** dieselbe Mittel aufweist, um für mindestens einen der Meßparameter in Abhängigkeit von einem Startsignal die Zeit festzulegen, wann und/oder in welchen Zeitabständen dieser gemessen wird.

36. Einrichtung nach einem der vorstehenden Ansprüche, **dadurch gekennzeichnet, daß** für mindestens einen der Meßparameter ein unterer und ein oberer Grenzwert einstellbar ist, wobei automatisch festgestellt wird, ob der gemessene Wert für diesen Parameter innerhalb des eingestellten, erlaubten Bereiches liegt.

37. Einrichtung nach Anspruch 36, **dadurch gekennzeichnet, daß** eine optische und/oder akustische Mitteilung erfolgt, die mitteilt, ob der gemessene Wert für diesen Parameter innerhalb oder außerhalb des eingestellten, erlaubten Bereiches liegt.

38. Einrichtung nach einem der vorstehenden Ansprüche, **dadurch gekennzeichnet, daß** dieselbe eine graphische Benutzeroberfläche aufweist zur Einstellung der Parameter der elektrischen Signale, mit denen die Kontaktflächen beaufschlagt werden.

39. Einrichtung nach Anspruch 38, **dadurch gekennzeichnet, daß** die graphische Benutzeroberfläche mindestens einen Schieberegler zur Einstellung von wenigstens einem Parameter von mindestens einem elektrischen Signal aufweist, mit dem eine Chipkarten-Kontaktfläche beaufschlagt wird.

40. Einrichtung nach Anspruch 38, **dadurch gekennzeichnet, daß** die graphische Benutzeroberfläche mindestens ein Eingabefenster zur Eingabe von wenigstens einem Parameter von mindestens einem elektrischen Signal aufweist, mit dem eine Chipkarten-Kontaktfläche beaufschlagt wird.

41. Einrichtung nach Anspruch 38, **dadurch gekennzeichnet, daß** die graphische Benutzeroberfläche mindestens ein Ausgabefenster zur Anzeige von wenigstens einem gemessenen Parameter von mindestens einem elektrischen Signal aufweist.

## Claims

1. An appliance for testing the functionality of a chip card with contacts, which has electrical contact areas for operating the integrated semiconductor module arranged in the chip card and for its communication with a chip card terminal, wherein the chip card terminal subjects the contact areas to electrical signals (Vcc, CLK, RST, I/O, GND), and also receives electrical signals (I/O) from the chip card, via at least one of the contact areas, wherein
- a contacting unit is equipped with contact elements that can respectively be contacted, in an electrically conductive manner, with the corresponding contact areas of the chip card,
- an electrical control and evaluation unit is connected to the contact elements of the bonding unit, in order to subject the contact areas to electrical signals (Vcc, CLK, RST, I/O, GND) and to receive electrical signals (I/O) from at least one contact area, wherein
- via the control and evaluation unit, at least one parameter of at least one electrical signal to which the one contact area is subjected can be changed,
- for test purposes, the control and evaluation unit measures at least one parameter of at least one electrical signal, **characterised in that** for measuring current [it] has an analog/digital converter which, for current measurement, converts the voltage drop at a precision resistor into a digital signal,
- and for checking a short-circuit from one contact area to at least one further contact area of the control and evaluation unit, the contact area to be tested is placed on a first voltage level, and at least one further contact area is placed on a second voltage level, wherein the control and evaluation unit measures at least the current to or from the contact area to be tested and/or at least the voltage on the contact area to be tested.

2. An appliance in accordance with claim 1, **characterised in that** in order to check that there is a perfect electrical connection from one contact area to the corresponding connection point on the integrated semiconductor module, the contact area to be tested is subjected by the control and evaluation unit to a voltage that is different from a reference voltage, wherein the control and evaluation unit measures the current to or from the contact area that is to be tested.

3. An appliance in accordance with claim 2, **characterised in that** the contact area to be tested is subjected to at least two different voltages, one after the other, wherein in each case the current to or from the contact area that is to be tested is measured.

4. An appliance in accordance with claim 3, **characterised in that** the contact area to be tested is subjected at least once to a voltage that is higher than the reference voltage and at least once to a voltage that is smaller than the reference voltage, wherein in each case the current to or from the contact area that is to be tested is measured.

5. An appliance in accordance with one of the preceding claims 2 to 4, **characterised in that** the voltage is successively altered (raised or lowered), starting from a starting value, wherein the current and/or the current rise is/are measured.

6. An appliance in accordance with claim 5, **characterised in that** the speed at which the voltage is altered is adjustable.

7. An appliance in accordance with claim 1, **characterised in that** in order to check that there is a perfect electrical connection from a contact area to the corresponding connection point on the integrated semiconductor module, a current is impressed on the contact area that is to be tested.

8. An appliance in accordance with one of the preceding claims, **characterised in that** after activation of the chip card, a previously determined bit sequence (Answer To Reset, ATR) transmitted from the chip card is read out by the control and evaluation unit.

9. An appliance in accordance with one of the preceding claims, **characterised in that** it has means for setting the supply voltage signal (Vcc) for the chip card.

10. An appliance in accordance with claim 9, **characterised in that** it has a digital/analog converter or a voltage potentiometer for setting the supply voltage signal (Vcc).

11. An appliance in accordance with one of the preceding claims, **characterised in that** it has means for setting a high voltage level of information bits that are to be transmitted and are sent to the I/O contact area.

12. An appliance in accordance with claim 11, **characterised in that** it has a digital/analog converter or a voltage potentiometer for setting the high voltage level.

13. An appliance in accordance with one of the preceding claims, **characterised in that** it has means for setting a low voltage level of information bits that are to be transmitted and are sent to the I/O contact area.

14. An appliance in accordance with claim 13, **characterised in that** it has a digital/analog converter or a voltage potentiometer for setting the low voltage level.

15. An appliance in accordance with one of the preceding claims, **characterised in that** it has an adjustable frequency generator for a timing signal (CLK) that is to be sent to one of the contact areas.

16. An appliance in accordance with claim 15, **characterised in that** it has means for altering a relation ("duty cycle") of a high level time to a low level time within a period of the timing signal (CLK) that is to be sent.

17. An appliance in accordance with claim 16, **characterised in that** it has means for setting the high voltage level of the timing signal (CLK) that is to be sent.

18. An appliance in accordance with claim 17, **characterised in that** it has a digital/analog converter or a voltage potentiometer for setting the high voltage level.

19. An appliance in accordance with claim 16, **characterised in that** it has means for setting the low voltage level of the timing signal (CLK) that is to be sent.

20. An appliance in accordance with claim 19, **characterised in that** it has a digital/analog converter or a voltage potentiometer for setting the low voltage level.

21. An appliance in accordance with one of the preceding claims, **characterised in that** it has means for setting a high voltage level of a reset signal (RST) that is to be sent to one of the contact areas.

22. An appliance in accordance with claim 21, **characterised in that** it has a digital/analog converter or a voltage potentiometer for setting the high voltage level.

23. An appliance in accordance with one of the preceding claims, **characterised in that** it has means for setting a low voltage level of a reset signal (RST) that is to be sent to one of the contact areas.

24. An appliance in accordance with claim 23, **characterised in that** it has a digital/analog converter or a voltage potentiometer for setting the low voltage level.

25. An appliance in accordance with one of the preceding claims, **characterised in that** it has means for measuring the current that flows to or from the chip card contact area for the supply voltage (Vcc).

26. An appliance in accordance with one of the preceding claims, **characterised in that** it has means for measuring the current that flows to or from the chip card contact area for the data exchange (I/O).

27. An appliance in accordance with one of the preceding claims, **characterised in that** it has means for measuring a voltage difference between the chip card contact area for the data exchange (I/O) and a reference voltage.

28. An appliance in accordance with claim 27, **characterised in that** it has an analog/digital converter for measuring the voltage difference.

29. An appliance in accordance with one of the preceding claims, **characterised in that** it has means for measuring the current that flows to or from the chip card contact area for the reset signal (RST).

30. An appliance in accordance with one of the preceding claims, **characterised in that** it has means for measuring a voltage difference between the chip card contact area for the reset signal (RST) and a reference voltage.

31. An appliance in accordance with claim 30, **characterised in that** it has an analog/digital converter for measuring the voltage difference.

32. An appliance in accordance with one of the preceding claims, **characterised in that** it has means for measuring the current that flows to or from the chip card contact area for the timing signal (CLK).

33. An appliance in accordance with one of the preceding claims, **characterised in that** it has means for setting a data transmission rate for the transmission of data to the contact area for the data exchange (I/O).

34. An appliance in accordance with one of the preceding claims, **characterised in that** it has means for setting the data reception rate for receiving data from the contact area for the data exchange (I/O).

35. An appliance in accordance with one of the preceding claims, **characterised in that** it has means for specifying, for at least one of the measurement parameters, depending on a starting signal, the time when, or at what time intervals, it is measured.

36. An appliance in accordance with one of the preceding claims, **characterised in that** for at least one of the measurement parameters, a lower and an upper limit value can be set, wherein it is automatically established whether the measured value for this parameter lies within the set permitted range.

37. An appliance in accordance with claim 36, **characterised in that** an optical and/or acoustic announcement is made, which indicates whether the measured value for this parameter lies within or outside the set permitted range.

38. An appliance in accordance with one of the preceding claims, **characterised in that** it has a graphical user interface for setting the parameters of the electrical signals to which the contact areas are subjected.

39. An appliance in accordance with claim 38, **characterised in that** the graphical user interface has at least one slider control for setting at least one parameter of at least one electrical signal to which a chip card contact area is subjected.

40. An appliance in accordance with claim 38, **characterised in that** the graphical user interface has at least one input window for inputting at least one parameter of at least one electrical signal to which a chip card contact area is subjected.

41. An appliance in accordance with claim 38, **characterised in that** the graphical user interface has at least one output window for displaying at least one measured parameter of at least one electrical signal.

## Revendications

1. Appareil pour tester la fonctionnalité d'une carte à puce avec des contacts, qui présente des surfaces de contact électrique pour l'exploitation et pour la communication du module à semi-conducteur intégré, disposé dans la carte à puce, avec un terminal de carte à puce, ledit terminal de carte à puce soumettant les surfaces de contact à des signaux électriques (Vcc, CLK, RST, I/O, GND) et recevant également des signaux électriques (I/O) de la carte à puce, par l'intermédiaire d'au moins l'une des surfaces de contact, dans lequel
- une unité de contact est équipée d'éléments de contact, entre lesquels et les surfaces de contact correspondantes de la carte à puce, le contact peut être établi, en mode de conduction électrique,
- une unité de commande et d'évaluation électronique est reliée aux éléments de contact de l'unité de mise en contact pour soumettre les surfaces de contact à des signaux électriques (Vcc, CLK, RST, I/O, GND) et recevoir des signaux électriques (I/O) d'au moins une surface de contact,
- par l'intermédiaire de l'unité de commande et d'évaluation, au moins un paramètre d'au moins un signal électrique, auquel une surface de contact est soumise, peut être modifié,
- par l'unité de commande et d'évaluation, au moins un paramètre d'au moins un signal électrique est mesuré aux fins de test, **caractérisé en ce que**, pour la mesure du courant, (il) présente un convertisseur analogigue / numérique qui, pour mesurer le courant, convertit la chute de tension à une résistance de mesure en un signal numérique,
- et que, pour contrôler un court-circuit d'une surface de contact part rapport à au moins une autre surface de contact de l'unité de commande et d'évaluation, la surface de contact à tester est mise à une lère valeur de voltage, et au moins une autre surface de contacte est mise à une 2ème valeur voltage, l'unité de commande et d'évaluation mesurant le courant à destination ou en provenance de la surface de contact à tester et / ou au moins la tension sur la surface de contact à tester.

2. Appareil selon la revendication 1, **caractérisé en ce que**, pour tester si la connexion électrique est impeccable entre une surface de contact et le point correspondant de connexion au module à semi-conducteur intégré, la surface de contact à tester est soumise par l'unité de commande et d'exploitation à une tension qui diffère d'une tension de référence, le courant à destination ou en provenance de la surface de contact à tester étant mesuré par ladite unité de commande et d'exploitation.

3. Appareil selon la revendication 2, **caractérisé en ce que** la surface de contact à tester est soumise successivement à au moins deux tensions différentes, le courant à destination ou en provenance de la surface de contact à tester étant chaque fois mesuré.

4. Appareil selon la revendication 3, **caractérisé en ce que** la surface de contact à tester est soumise, une fois au moins, à une tension qui est supérieure à la tension de référence, et est soumise, une fois au moins, à une tension qui est inférieure à la tension de référence, le courant à destination ou en provenance de la surface de contact à tester étant chaque fois mesuré.

5. Appareil selon l'une des revendications précédentes 2 à 4, **caractérisé en ce que** la tension est successivement modifiée (augmentée ou réduite), à partir d'une valeur de départ, le courant et / ou l'augmentation de courant étant mesuré/s.

6. Appareil selon la revendication 5, **caractérisé en ce que** la vitesse de modification de la tension électrique peut être réglée.

7. Appareil selon la revendication 1, **caractérisé en ce que**, pour vérifier le caractère impeccable de la connexion électrique d'une surface de contact par rapport au point correspondant de connexion à un module à semi-conducteur intégré, un courant est appliqué sur la surface de contact à tester.

8. Appareil selon l'une des revendications précédentes, **caractérisé en ce que**, après une activation de la carte à puce, une séquence de bits prédéterminée (Anwer-To-Reset, ATR), transmise par la carte à puce, est extraite par l'unité de commande et d'évaluation.

9. Appareil selon l'une des revendications précédentes, **caractérisé en ce que** celui-ci présente des moyens de réglage d'un signal de tension d'alimentation (Vcc) pour la carte à puce.

10. Appareil selon la revendication 9, **caractérisé en ce que** celui-ci présente un convertisseur analogique / numérique ou un potentiomètre de tension pour le réglage du signal de tension d'alimentation (Vcc).

11. Appareil selon l'une des revendications précédentes, **caractérisé en ce que** celui-ci présente des moyens pour le réglage d'un haut niveau de tension de bits d'information à transmettre, qui sont appliquées à la surface de contact I/O.

12. Appareil selon la revendication 11, **caractérisé en ce que** celui présente un convertisseur analogique / numérique ou un potentiomètre tension pour le réglage du haut niveau de tension.

13. Appareil selon l'une des revendications précédentes, **caractérisé en ce que** celui présente des moyens pour le réglage d'un bas niveau de tension de bits d'information à transmettre, qui sont appliquées à la surface de contact I/O.

14. Appareil selon la revendication 13, **caractérisé en ce que** celui présente un convertisseur analogique / numérique ou un potentiomètre tension pour le réglage du bas niveau de tension.

15. Appareil selon l'une des revendications précédentes, **caractérisé en ce que** celui présente un générateur de fréquence réglable pour un signal d'horloge (CLK) à envoyer à l'une des surfaces de contact.

16. Appareil selon la revendication 15, **caractérisé en ce que** celui présente des moyens pour modifier une relation (« Duty Cycle ») entre un temps de haut niveau et un temps de bas niveau, pendant une durée de période du signal d'horloge (CLK) à transmettre.

17. Appareil selon la revendication 16, **caractérisé en ce que** celui présente des moyens pour le réglage du haut niveau de tension du signal d'horloge (CLK) à transmettre.

18. Appareil selon la revendication 17, **caractérisé en ce que** celui présente un convertisseur analogique / numérique ou un potentiomètre tension pour le réglage du haut niveau de tension.

19. Appareil selon la revendication 16, **caractérisé en ce que** celui présente des moyens pour le réglage du bas niveau de tension du signal d'horloge (CLK) à envoyer.

20. Appareil selon la revendication 19, **caractérisé en ce que** celui présente un convertisseur analogique / numérique ou un potentiomètre tension pour le réglage du bas niveau de tension.

21. Appareil selon l'une des revendications précédentes, **caractérisé en ce que** celui présente des moyens pour le réglage d'un haut niveau de tension d'un signal Reset (RST) à transmettre à l'une des surfaces de contact.

22. Appareil selon la revendication 21, **caractérisé en ce que** celui présente un convertisseur analogique / numérique ou un potentiomètre tension pour le réglage du haut niveau de tension.

23. Appareil selon l'une des revendications précédentes, **caractérisé en ce que** celui présente des moyens pour le réglage d'un bas niveau de tension d'un signal Reset (RST) à transmettre à l'une des surfaces de contact.

24. Appareil selon la revendication 23, **caractérisé en ce que** celui présente un convertisseur analogique / numérique ou un potentiomètre tension pour le réglage du bas niveau de tension.

25. Appareil selon l'une des revendications précédentes, **caractérisé en ce que** celui présente des moyens pour mesurer le courant qui circule en provenance ou à destination de la surface de contact de la carte à puce pour la tension d'alimentation (Vcc).

26. Appareil selon l'une des revendications précédentes, **caractérisé en ce que** celui présente des moyens pour mesurer le courant qui circule en provenance ou à destination de la surface de contact de la carte à puce pour l'échange de données (I/O).

27. Appareil selon l'une des revendications précédentes, **caractérisé en ce que** celui présente des moyens pour mesurer une différence de tension entre la surface de contact de la carte à puce pour l'échange de données (I/O) et une tension de référence.

28. Appareil selon la revendication 27, **caractérisé en ce que** celui présente un convertisseur analogique / numérique pour mesurer la différence de tension.

29. Appareil selon l'une des revendications précédentes, **caractérisé en ce que** celui présente des moyens pour mesurer le courant qui circule à destination ou en provenance de la surface de contact de la carte à puce pour le signal Reset (RST).

30. Appareil selon l'une des revendications précédentes, **caractérisé en ce que** celui présente des moyens pour mesurer une différence de tension entre la surface de contact de la carte à puce pour le signal Reset (RST) et une tension de référence.

31. Appareil selon la revendication 30, **caractérisé en ce que** celui présente un convertisseur analogique / numérique pour mesurer la différence de tension.

32. Appareil selon l'une des revendications précédentes, **caractérisé en ce que** celui présente des moyens pour mesurer le courant qui circule à destination ou en provenance de la surface de contact de la carte à puce pour le signal d'horloge (CLK).

33. Appareil selon l'une des revendications précédentes, **caractérisé en ce que** celui présente des moyens pour le réglage d'un taux de transfert de données pour la transmission de données à la surface de contact, lors de l'échange de données (I/O).

34. Appareil selon l'une des revendications précédentes, **caractérisé en ce que** celui présente des moyens pour régler le taux de réception de données pour la réception de données par la surface de contact, lors de l'échange de données (I/O).

35. Appareil selon l'une des revendications précédentes, **caractérisé en ce que** celui présente des moyens pour fixer, en dépendance d'un signal de démarrage, pour au moins l'un des paramètres, le moment auquel et / ou à quels intervalles celui-ci doit être mesuré.

36. Appareil selon l'une des revendications précédentes, **caractérisé en ce que**, pour au moins l'un des paramètres de mesure, une valeur limite inférieure et supérieure peut être réglée, ce faisant étant constaté automatiquement si la valeur mesurée pour ce paramètre est située dans ou hors du domaine permis.

37. Appareil selon la revendication 36, **caractérisé en ce qu'**un message optique et / ou acoustique est lancé, lequel informe si la valeur mesurée pour ce paramètre est située dans ou hors du domaine permis.

38. Appareil selon l'une des revendications précédentes, **caractérisé en ce que** celui-ci présente une interface utilisateur graphique pour le réglage des paramètres des signaux électriques auxquels sont soumises les surfaces de contact.

39. Appareil selon la revendication 38, **caractérisé en ce que** l'interface utilisateur graphique présente au moins un régleur à décalage pour le réglage d'au moins un paramètre d'au moins un signal électrique, auquel est soumise une surface de contact de la carte à puce.

40. Appareil selon la revendication 38, **caractérisé en ce que** l'interface utilisateur graphique présente au moins une fenêtre d'entrée pour l'introduction d'au moins un paramètre d'au moins un signal électrique auquel est soumise la surface de contact de la carte.

41. Appareil selon la revendication 38, **caractérisé en ce que** l'interface utilisateur graphique présente, au moins, une fenêtre de sortie pour l'affichage d'au moins un paramètre mesuré d'au moins un signal électrique.
